(19)

**Europäisches Patentamt**

**European Patent Office**

**Office européen des brevets**

(11) **EP 4 614 760 A1**

(12) **EUROPEAN PATENT APPLICATION**

(43) Date of publication:
**10.09.2025 Bulletin 2025/37**

(21) Application number: **25155916.7**

(22) Date of filing: **05.02.2025**

(51) International Patent Classification (IPC):
**H02J 7/00** (2006.01) **H01M 10/48** (2006.01)
**H01M 10/42** (2006.01)

(52) Cooperative Patent Classification (CPC):
**H02J 7/005; H01M 10/48; H01M 10/486;**
**H02J 7/0016;** H01M 2010/4271

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **08.02.2024 DE 102024103577**
**14.02.2024 DE 102024104161**

(71) Applicant: **Skeleton Technologies GmbH**
**04420 Markranstädt (DE)**

(72) Inventor: **Raska, Martin**
**69310 Laatsi (EE)**

(74) Representative: **KASTEL Patentanwälte PartG mbB**
**St.-Cajetan-Straße 41**
**81669 München (DE)**

(54) **A METHOD FOR OPERATING AN ENERGY STORAGE SYSTEM, AN ENERGY STORAGE RACK, OR AN ENERGY STORAGE MODULE**

(57) In order to mitigate thermal effects on the aging of energy storage cells (18), the invention proposes a method for operating an energy storage module (16) having multiple energy storage cells (18) in order to mitigate thermal aging effects on the energy storage cells (18), the method comprising:

a) obtaining a cell lifetime for at least one each energy storage cell (18), wherein the cell lifetime depends at least on thermal effects and voltage effects; and

for each energy storage cell (18):

b) determining a thermal cell aging factor, that is indicative of an aging process of the energy storage cell (18) due to thermal effects;

c) determining a voltage offset required to obtain the lifetime obtained in step a); and

d) activating balancing of the respective energy storage cell (18) based on the voltage offset obtained in step c).

FIG. 3

## Description

The invention relates to a method for operating an energy storage system, an energy storage rack, or an energy storage module with multiple energy storage cells.

Energy storage systems that include multiple energy storage cells typically require some sort of management of cell voltages. This may have different causes, such as variations in manufacturing or - over time - degradation of the cells depending on environmental conditions or usage conditions, for example.

Energy storage cells as described herein may be classified into three varieties: batteries, capacitors and ultracapacitors (sometimes also called supercapacitors).

The term "battery" as used herein is an energy storage cell that stores electrical energy exclusively by electrochemical redox reaction. This typically includes primary batteries that can only be discharged. However, as used herein, the term "battery" exclusively means secondary battery, i.e., a battery that may be charged and discharged.

The term "capacitor" as used herein is an energy storage cell that stores electrical energy electrostatically.

The term "ultracapacitor" as used herein is a special kind of capacitor and may be further distinguished into a double-layer capacitor (DLC) that stores energy electrostatically using a Helmholtz double layer, a pseudocapacitor that stores electrical energy electrochemically by Faradaic electron charge-transfer such as intercalation or electrosorption, or a hybrid capacitor that uses both mechanisms of the DLC and the pseudocapacitor.

Energy storage modules based on ultracapacitors are becoming more and more popular in various applications. Applications are, for example, grid stabilization, high-power power supplies, and off-shore automation. Ultracapacitors can be easily charged and are able to provide large peak powers within a short amount of time, which is ideal for these applications.

A significant factor determining the lifetime of the energy storage modules is the aging of the individual energy storage cells within that module. Temperature variations have a noticeable impact on the aging process and as a result on the lifetime of the energy storage cells. Generally, the lifetime of the energy storage module is determined by the energy storage cell with the lowest lifetime.

Thermal management within the energy storage modules is therefore an important topic in this field and has been addressed in different ways.

Unpublished German patent application 10 2023 111 690.8 discloses a support structure for an energy storage module with multiple energy storage cells. The structure is designed to allow for a more uniform temperature distribution between the energy storage cells, thereby allowing roughly the same aging conditions. This is achieved by special arrangement of ventilations holes in the support structure.

Unpublished German patent application 10 2023 117 427.4 discloses an energy storage module with temperature based cell voltage control for high-power applications. The controller measures the temperature of a cell of the energy storage module and upon certain thresholds adjusts the respective cell voltage with the goal of mitigating temperature effects on the lifetime of the cells.

Unpublished German patent application 10 2024 102 852.1 discloses an abnormal cell detection and balancing method for compensating the abnormally behaving cells.

Weighted balancing is typically applied to keep the voltage imbalance between different cells within an energy storage system as small as possible. Balancing methods are well-known and reference is made to the following documents:

US 2013 / 0 278227 A1
CN 103 891 087 A
CN 105 471 010 A
WO 2014 / 057 088 A2
CN 105 471 010 A
CN 110 768 237 A
CN 107 800 292 A
CN 107 257 147 A
US 9 525 298 B1
CN 105 471 010 A
CN 104 410 132 A
CN 101 414 759 B
CN 103 066 664 B

It is the object of the invention to improve energy storage systems, preferably regarding lifetime and energy content.

The object is achieved by the subject-matter of the independent claims. Preferred embodiments are subject-matter of the dependent claims.

The invention provides a method for operating an energy storage system, an energy storage rack, or an energy storage module having multiple energy storage cells, preferably in order to mitigate thermal aging effects on the energy storage cells, the method comprising:

a) obtaining a cell lifetime for at least one each energy storage cell, wherein the cell lifetime depends at least on thermal effects and voltage effects; and

for each energy storage cell:

b) determining a thermal cell aging factor, that is indicative of an aging process of the energy storage cell due to thermal effects;

c) determining a voltage offset required to obtain the lifetime obtained in step a); and

d) activating balancing of the respective energy storage cell based on the voltage offset obtained in step c).

Preferably, in step a) obtaining the cell lifetime involves determining a cell temperature of at least one energy storage cell and determining the cell lifetime based on the cell temperature.

Preferably, determining the cell lifetime involves determining at least one cell aging factor, preferably the thermal cell aging factor and/or a voltage cell aging coefficient, and the cell lifetime is determined based on each cell aging factor.

Preferably, the cell lifetime is that of the coldest energy storage cell.

Preferably, determining a cell temperature involves measuring a temperature with temperature sensors arranged at distributed measuring points within the energy storage module, calculating a temperature distribution within the energy storage module based on the measurements, and selecting a temperature value from the temperature distribution at the location of the energy storage cell within the energy storage module as the cell temperature.

Preferably, the amount of distributed measuring points is smaller than the number of energy storage cells, preferably smaller than half the number of energy storage cells.

Preferably, in step c) determining the offset voltage involves determining a voltage cell aging factor that is indicative of an aging process of the energy storage cell due to voltage effects.

Preferably, in step d) balancing is switched on, if the voltage offset of step c) exceeds a predetermined threshold.

Preferably, the method further comprises the step:

e) if the energy storage module is discharging and supplying power, the energy storage module is discharged until one energy storage cell reaches 0 % state of charge (SoC) or reaches a cell voltage of 0 V; or the energy storage module is discharged until the energy storage module reaches half the nominal voltage, quarter the nominal voltage, or 10 % the nominal voltage.

The invention provides a management system for an energy storage system, for an energy storage rack, or for an energy storage module that is configured for storing electrical energy and comprises a plurality of energy storage cells, preferably ultracapacitors, wherein the management system is configured to carry out a preferred method.

The invention provides an energy storage system, an energy storage rack, or an energy storage module comprising a plurality of energy storage cells, preferably ultracapacitors, and the management system.

The invention provides a computer program comprising instructions that, upon execution by a management system, cause the management system to carry out a preferred method.

The invention provides a computer-readable storage medium comprising the computer program.

Advantageous effects and other features of this idea will be described below. It should be noted that not all advantages need to be present at the same time or to the same degree.

Thermal mitigation is an important part of energy storage management. Here, the idea is to implement thermal balancing. During thermal balancing, the cell voltage is lowered on higher temperature cells. The goal is to equalize the lifetime of all energy storage cells in a system. In contrast, the current approach only balances the cell voltages equally and does not consider other parameters that can affect cell lifetime.

Uneven temperatures of the energy storage cells are typically caused by the mechanical design of the energy storage module, where in particular the energy storage cells in the center of the energy storage module have less surface area to the outside than the energy storage cells in outer positions. Thus, heat can usually escape much more easily from the outer energy storage cells compared to those near the center. In some cases the heat can get trapped due to relying on natural convection cooling.

Another possible source of uneven cell temperatures could be the balancing circuit. Furthermore, the rack design might also impact the temperature distribution of the energy storage cells.

The current approach of the cell voltage balancing algorithm is to keep cell voltages equal within one rack/system. This means that lifetime differences due to the temperature differences can be expected. Assuming that a module lifetime is generally defined by the most aged cell, then the module is typically replaced when the first cell reaches the end of life. Therefore, plenty of cell lifetime is wasted due to the uneven aging of the cells.

As of yet, this uneven aging was addressed by oversizing the system, when a certain expected lifetime was needed. This was done by having more energy storage modules in series which in turn allows a decrease of the average cell voltage in the system.

The lifetime of energy storage cells, and in particular of ultracapacitors, is mainly affected by cell temperature and cell voltage. The effects of both can be described via aging factors (AF) which are the relative change multiplier in expected lifetime.

The thermal cell aging factor ($AF_T$) is based on a modified Arrhenius equation. In most cases, the equation can be generalized as doubling the reaction rate for every 10 °C increase in temperature T, if temperature is below a temperature threshold Ts, and doubling the reaction rate for every 5 °C increase in temperature above the temperature threshold:

$$AF_T = 2^{\frac{T_{cell}-T_S}{T_D}}, \quad (1)$$

where $T_{cell}$ is the cell temperature, Ts is the temperature threshold, and $T_D$ is the doubling temperature (i.e. 10 °C

**EP 4 614 760 A1**

or 5°C) as described above. The temperature threshold depends on the type of energy storage cell and can be obtained from experiment.

The voltage cell aging factor (AFv) can be modeled with a similar form to the Arrhenius equation, but uses two different voltage ranges. At voltages below a voltage threshold, the reaction rate is doubled for a given voltage increase. At voltages above the voltage threshold, the reaction rate is doubled for every half of the given voltage increase:

$$AF_V = 2^{\frac{V_{\text{cell}}-V_S}{V_D}}, \quad (2)$$

where $V_{\text{cell}}$ is the cell voltage, $V_S$ is the voltage threshold, and $V_D$ is the doubling voltage (typically less than a tenth of the cell voltage). The reason for this is that as the voltage is increased, not only do the rates of side reactions from impurities increase, but also the number of possible side reactions increase. The voltage threshold and the voltage increase depend on the type of energy storage cell and can be obtained from experiment.

The cell lifetime ($LT_{\text{cell}}$) can be estimated from a base level lifetime ($LT_B$) at well-defined conditions, where the base lifetime is again determined by experiment:

$$LT_{\text{cell}} = \frac{LT_B}{AF_T \cdot AF_V} \quad (3)$$

Thermal balancing is the methodology disclosed herein to control the individual cell voltage based on the cell temperature with the goal of aging all energy storage cells as evenly as possible inside the module. As stated previously, both the cell voltage and the cell temperature contribute to the aging of the capacitor cells. This means that lowering the cell temperature or the cell voltage can be used to increase the total usable cell lifetime. Since the cell temperature is typically given by the circumstances of the operation and may vary accordingly, changing the cell voltage can be used to adjust the aging of the respective energy storage cell. In particular, lowering the cell voltage of energy storage cells that experience a higher cell temperature allows equalizing the aging of the energy storage cells in the module.

Embodiments of the invention are described in more detail with reference to the accompanying schematic drawings that are listed below

Fig. 1    depicts an embodiment of an energy storage system;

Fig. 2    depicts an embodiment of an energy storage module;

Fig. 3    depicts an embodiment of a method for operating the energy storage system;

Fig. 4    depicts a voltage-lifetime diagram;

Fig. 5    depicts an energy-lifetime diagram; and

Fig. 6    depicts an energy gain-lifetime diagram.

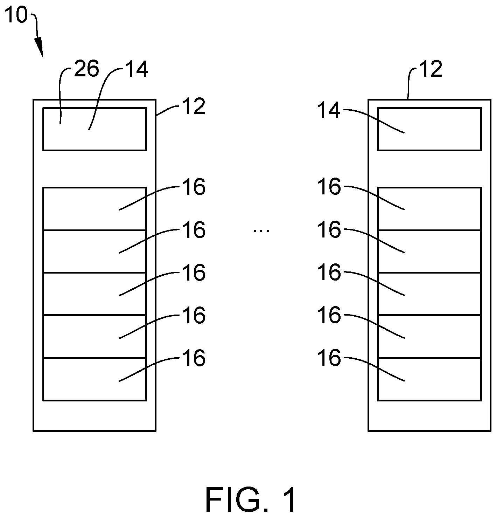

Referring to Fig. 1 an embodiment of an energy storage system 10 is schematically depicted. The energy storage system 10 may be used for grid stabilization, in particular for mitigating the effects of power sags or power disruptions, or for providing peak loads during ramp-up of power intensive machinery or equipment.

The energy storage system 10 may include one or more energy storage racks 12. The energy storage racks 12 are suitably connected according to the application. The energy storage racks 12 are connected in parallel or in series depending on the application.

Each energy storage rack 12 includes a rack controller 14 and a plurality of energy storage modules 16. The rack controller 14 is configured to control the energy storage modules 16 that are installed in the respective energy storage rack 12. A plurality of rack controllers 14 may operationally form a system controller by communicating with each other. It is also possible for the energy storage system 10 to include a separate system controller (not shown) that communicates with and controls the energy storage racks 12 via the rack controllers 14.

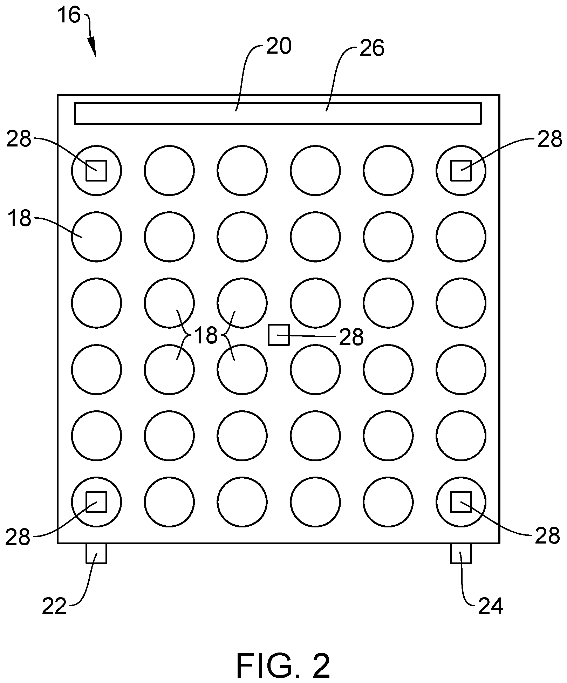

Referring to Fig. 2 the energy storage module 16 is described in more detail. The energy storage module 16 comprises a plurality of energy storage cells 18 and a module controller 20. A first and second terminal 22, 24 are formed on the energy storage module 16, which allow electrical connection to other energy storage modules 16, preferably of the same energy storage rack 12.

The module controller 20 is configured to control general operation of the energy storage module 16, in particular charging and discharging of the energy storage cells 18. Furthermore, the module controller 20 is operatively coupled to each individual cell to allow controlling a cell voltage $V_{\text{cell}}$ of each individual energy storage cell 18. In particular the module controller 20 allows decreasing of the cell voltage $V_{\text{cell}}$ during balancing, preferably by discharging the respective energy storage cell 18 using a balancing circuit. In its simplest form the balancing circuit involves a switch, e.g., a transistor, and a balancing resistor.

As indicated in Fig. 2, the innermost energy storage cells 18 have a higher temperature than more outer located energy storage cells 18. It is also indicated that energy storage cells 18 closer to the module controller 20 may experience a higher cell temperature.

Each module controller 20 may be operatively coupled to the rack controller 14. In some embodiments, two or more module controllers 20 may collectively form the rack controller 14 without a separate physical component present. It is also possible, that each module controller 20 is integrated into the rack controller 14 as a physical and/or software component thereof.

The rack controller 14, the system controller, and the module controller 20, as the case may be, may be collectively referred to as a management system 26.

The energy storage module 16 further comprises a plurality of thermal sensors 28 that are distributed within the energy storage module 16. The thermal sensors 28 measure the local temperature in their vicinity and are coupled to the management system 26, which processes these data.

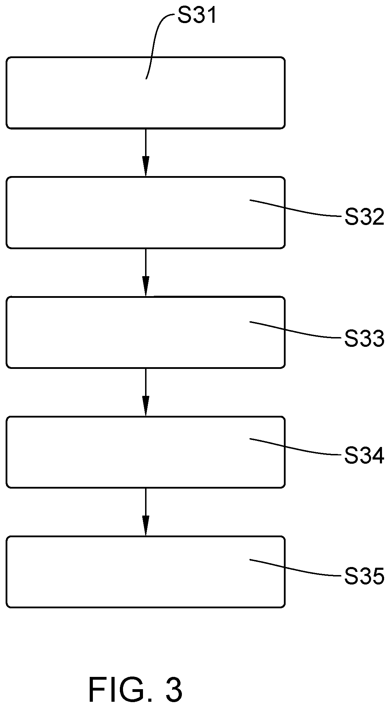

Referring to Fig. 3, an embodiment of a method for operating the energy storage system 10 is described in more detail.

In a lifetime calculation step S31, the management system 26 determines the cell lifetime of the coldest energy storage cell 18.

The management system 26 receives the temperatures measured by the temperature sensors 28. The management system 26 determines a temperature distribution from the measured temperatures. It is assumed that the energy storage cells 18 have a cell temperature $T_{cell}$ that corresponds to the temperature given by the temperature distribution at the respective location of the energy storage cell 18. The temperature distribution can be obtained based on simulation data that were generated by performing thermal simulations of the energy storage module 16 beforehand. These simulation data also help to identify the ideal locations for the temperature sensors 28. The thermal simulations may involve determining a temperature gradient and based on the gradient determining the cell temperature $T_{cell}$. It is also possible to determine the cell temperature $T_{cell}$ based on a look-up-table that is obtained from the simulation data. It should be noted that it is also possible to equip each and every energy storage cell 18 with a temperature sensor 28.

Based on the temperature distribution, the management system 26 identifies the coldest energy storage cell 18 and its cell temperature $T_{cell}$. Furthermore, the management system 26 determines the cell voltage $V_{cell}$ of that energy storage cell 18. The management system 26 determines the thermal and voltage cell aging factors $AF_T$ and $AFv$ according to equation (1) and (2), respectively. Next, the management system 26 determines the cell lifetime $LT_{cell}$ according to equation (3).

It should be noted that the cell lifetime $LT_{cell}$ need not be determined in exactly this manner. Other cell lifetime estimation models may be used, as long as the respective model includes a temperature dependence and a voltage dependence of the cell lifetime.

In a thermal aging factor calculation step S32, the management system 26 determines the thermal cell aging factors $AF_T$ of the remaining energy storage cells 18. It should be noted that it is possible to carry out the steps S31 and S32 simultaneously.

In a target voltage aging calculation step S33, the management system 26 determines the voltage cell aging factors $AFv$ of the remaining energy storage cells 18 such that these energy storage cells 18 have the same estimated cell lifetime $LT_{cell}$ as the coldest energy storage cell 18.

In a voltage offset calculation step S34, the management system 26 determines the voltage offset $V_{off}$ for each energy storage cell 18. The voltage offset $V_{off}$ is determined such that all energy storage cells 18 have the same estimated cell lifetime $LT_{cell}$ as the coldest energy storage cell 18. The voltage offset $V_{off}$ is determined based on equation (2) and the current cell voltage $V_{cell}$ of the respective energy storage cell 18.

It should be noted that the steps S33 and S34 may also be combined into a single calculation step.

In a balancing step S35, the management system 26 activates balancing for the energy storage cells 18 and applies the respective voltage offsets $V_{off}$. The balancing algorithm, e.g., weighted balancing, will then adjust the cell voltage $V_{cell}$ accordingly.

The management system 26 may also apply a threshold voltage $V_{thresh}$, such that only for energy storage cells 18 that require an absolute voltage offset $V_{off}$ greater than the threshold voltage $V_{thresh}$, i.e. $|V_{off}| > V_{thresh}$, balancing is activated. In a case, where the management system 26 can perform balancing only by reducing the cell voltage $V_{cell}$, balancing is only activated for energy storage cells 18 that require a decrease in the cell voltage $V_{cell}$ to achieve the desired estimated cell lifetime $LT_{cell}$.

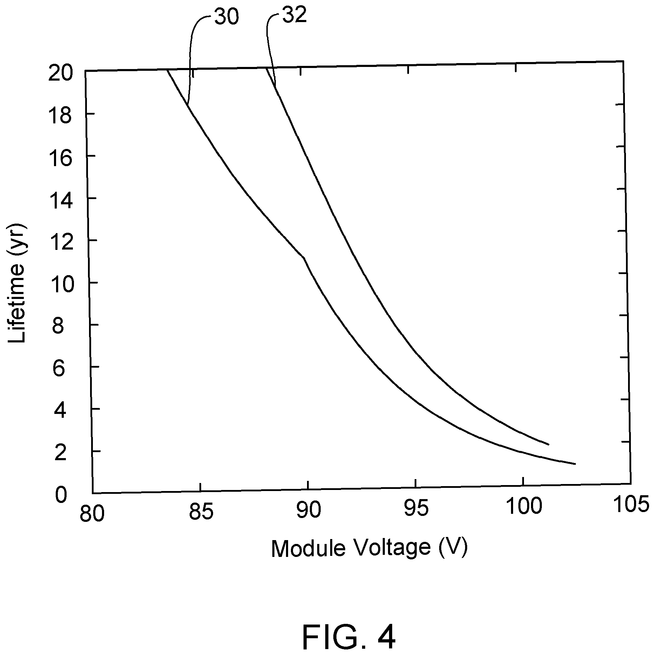

Referring to Fig. 4 through Fig. 6, simulation results of an energy storage module 16 that employs the previously described method are presented to show the effectiveness of the method.

Fig. 4 depicts a module lifetime diagram of the energy storage module 16, where the x-axis is the module voltage $V_{mod}$ and the y-axis is the module lifetime $LT_{mod}$.

The left curve 30 shows the uncompensated case, where all energy storage cells 18 in the energy storage module 16 have the same cell voltage $V_{cell}$.

The right curve 32 shows the compensated case, where the energy storage cells 18 are balanced according to the disclosed thermal balancing method, i.e., the cell voltages $V_{cell}$ are compensated by voltage offsets $V_{off}$ to have the same cell lifetime $LT_{cell}$. Surprisingly, the thermal balancing method allows the module voltage $V_{mod}$ to be higher given the lifetime as in the uncompensated case. The simulations have shown that the voltage offset $V_{off}$ to achieve the same cell lifetimes $LT_{cell}$ typically does not exceed 200 mV.

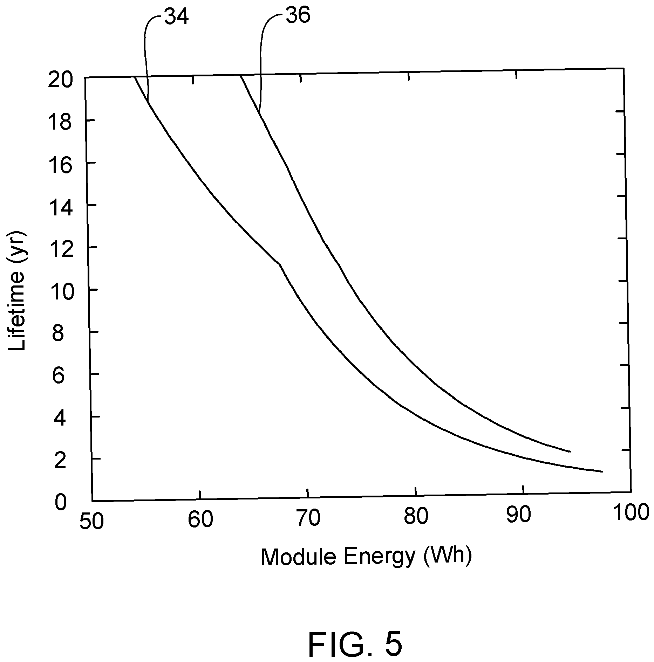

Fig. 5 depicts a module lifetime diagram of the energy storage module 16, where the x-axis is the module energy $E_{mod}$ (typically Wh) and the y-axis is the module lifetime $LT_{mod}$.

The left curve 34 shows the uncompensated case, where all energy storage cells 18 in the energy storage module 16 have the same cell voltage $V_{cell}$.

The right curve 36 shows the thermal balancing case according to the invention. As the thermal balancing allows an increase in the module voltage $V_{mod}$, the usable module energy can also be increased. Usable module energy is defined here as discharging the energy storage module 16 from the fully charged state down to half-nominal voltage.

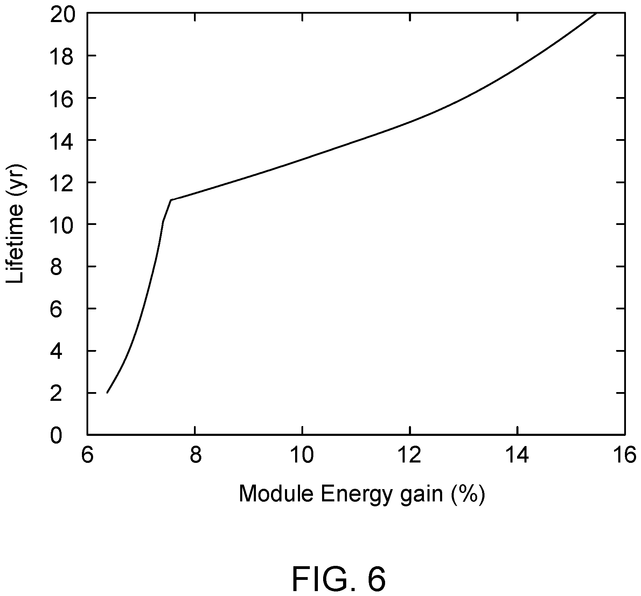

Fig. 6 depicts a module lifetime diagram of the energy storage module 16, where the x-axis is the module energy gained compared to the uncompensated case and the y-axis is the module target lifetime $LT_{mod}$.

The energy gain is at least 6 % compared to the uncompensated case and allows an energy gain of 15.5 % for a module design lifetime of 20 years. This energy gain due to thermal balancing is rather significant.

**List of reference signs**:

10   energy storage system
12   energy storage rack
14   rack controller
16   energy storage module
18   energy storage cell
20   module controller
22   first terminal
24   second terminal
26   management system
28   temperature sensor
30   left curve
32   right curve
34   left curve
36   right curve

**Claims**

1. A method for operating an energy storage system (10), an energy storage rack (12), or an energy storage module (16) having multiple energy storage cells (18), preferably in order to reduce the difference in aging effects among the energy storage cells (18), the method comprising:

    a) obtaining a cell lifetime for at least one each energy storage cell (18), wherein the cell lifetime depends at least on thermal effects and voltage effects; and
    for each energy storage cell (18):
    b) determining a thermal cell aging factor, that is indicative of an aging process of the energy storage cell (18) due to thermal effects;
    c) determining a voltage offset required to obtain the lifetime obtained in step a); and
    d) activating balancing of the respective energy storage cell (18) based on the voltage offset obtained in step c).

2. The method according to claim 1, wherein in step a) obtaining the cell lifetime involves determining a cell temperature of at least one energy storage cell (18) and determining the cell lifetime based on the cell temperature.

3. The method according to claim 2, wherein determining the cell lifetime involves determining at least one cell aging factor, preferably the thermal cell aging factor and/or a voltage cell aging coefficient, and the cell lifetime is determined based on each cell aging factor.

4. The method according to any of the preceding claims, wherein the cell lifetime is that of the coldest energy storage cell (18).

5. The method according to any of the preceding claims, wherein determining a cell temperature involves measuring a temperature with temperature sensors (28) arranged at distributed measuring points within the energy storage module (16), calculating a temperature distribution within the energy storage module (16) based on the measurements, and selecting a temperature value from the temperature distribution at the location of the energy storage cell (18) within the energy storage module (16) as the cell temperature.

6. The method according to claim 5, wherein the amount of distributed measuring points is smaller than the number of energy storage cells (18), preferably smaller than half the number of energy storage cells (18).

7. The method according to any of the preceding claims, wherein in step c) determining the offset voltage involves determining a voltage cell aging factor that is indicative of an aging process of the energy storage cell (18) due to voltage effects.

8. The method according to any of the preceding claims, wherein in step d) balancing is switched on, if the voltage offset of step c) exceeds a predetermined threshold.

9. The method according to any of the preceding claims further comprising:
e) if the energy storage module (16) is discharging and supplying power, the energy storage module (16) is discharged until one energy storage cell (18) reaches 0 % state of charge (SoC) or reaches a cell voltage of 0 V; or the energy storage module (16) is discharged until the energy storage module (16) reaches half the nominal voltage, quarter the nominal voltage, or 10 % the nominal voltage.

10. A management system (26) for an energy storage system (10), an energy storage rack (12), or an energy storage module (16) that is configured for storing electrical energy and comprises a plurality of energy storage cells (18), preferably ultracapacitors, wherein the management system (26) is configured to carry out a method according to any of the preceding claims.

**11.** An energy storage system (10), an energy storage rack (12), or an energy storage module (16) comprising a plurality of energy storage cells (18), preferably ultracapacitors, and a management system (26) according to claim 10.

**12.** A computer program comprising instructions that, upon execution by a management system (26), cause the management system (26) to carry out a method according to any of the claims 1 to 9.

**13.** A computer-readable storage medium comprising the computer program of claim 12.

FIG. 1

FIG. 2

S31

S32

S33

S34

S35

FIG. 3

FIG. 4

FIG. 5

FIG. 6

**EUROPEAN SEARCH REPORT**

Europäisches
Patentamt
European
Patent Office
Office européen
des brevets

**Application Number**

EP 25 15 5916

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/119746 A1 (MACRIS ERIC [US]) 17 May 2012 (2012-05-17) | 1-4,7,8, 11,13 | INV. H02J7/00 |
| Y | * paragraph [0022] * <br> * paragraph [0034] - paragraph [0037] * <br> ----- | 5,6 | H01M10/48 H01M10/42 |
| Y | US 2016/336765 A1 (TRIMBOLI MICHAEL SCOTT [US] ET AL) 17 November 2016 (2016-11-17) <br> * figures 1A, 2A * <br> * paragraph [0090] * <br> * paragraph [0117] * <br> * paragraph [0143] * <br> * paragraph [0187] - paragraph [0192] * <br> * paragraph [0201] * <br> * paragraph [0228] * <br> ----- | 5,6 | |
| A | WO 2020/259860 A1 (SMART POWER GMBH [DE]) 30 December 2020 (2020-12-30) <br> * the whole document * <br> ----- | 1-13 | |

**TECHNICAL FIELDS SEARCHED (IPC)**

H02J
H01M

The present search report has been drawn up for all claims

| Place of search | Date of completion of the search | Examiner |
|---|---|---|
| Munich | 7 July 2025 | Martin, Raynald |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 5916

This annex lists the patent family members relating to the patent documents cited in the above-mentioned European search report.
The members are as contained in the European Patent Office EDP file on
The European Patent Office is in no way liable for these particulars which are merely given for the purpose of information.

07-07-2025

| Patent document cited in search report | Publication date | Patent family member(s) | | Publication date |
|---|---|---|---|---|
| US 2012119746 A1 | 17-05-2012 | US | 2012119746 A1 | 17-05-2012 |
| | | WO | 2013095885 A1 | 27-06-2013 |
| US 2016336765 A1 | 17-11-2016 | US | 2015214757 A1 | 30-07-2015 |
| | | US | 2016336765 A1 | 17-11-2016 |
| | | US | 2016336767 A1 | 17-11-2016 |
| | | WO | 2015105923 A1 | 16-07-2015 |
| WO 2020259860 A1 | 30-12-2020 | EP | 3991261 A1 | 04-05-2022 |
| | | WO | 2020259860 A1 | 30-12-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102023111690
- DE 102023117427
- DE 102024102852
- US 20130278227 A1
- CN 103891087 A
- CN 105471010 A
- WO 2014057088 A2
- CN 110768237 A
- CN 107800292 A
- CN 107257147 A
- US 9525298 B1
- CN 104410132 A
- CN 101414759 B
- CN 103066664 B